Europäisches Patentamt

European Patent Office

Office européen des brevets

(11) Publication number: **0 489 522 A2**

# EUROPEAN PATENT APPLICATION

(21) Application number: **91310817.1**

(22) Date of filing: **25.11.91**

(51) Int. Cl.5: **H05K 1/00, H05K 3/00**

(30) Priority: **03.12.90 GB 9026236**

(43) Date of publication of application:
**10.06.92 Bulletin 92/24**

(84) Designated Contracting States:
**DE ES FR IT NL**

(71) Applicant: **GEC-Marconi Limited**
**The Grove Warren Lane**
**Stanmore Middlesex HA7 4LY(GB)**

(72) Inventor: **Mosley, Alan**
**6 Chiltern Park Avenue**
**Berkhamsted, HP4 1EU(GB)**

(74) Representative: **George, Sidney Arthur**
**The General Electric Company p.l.c. GEC**
**Patent Department(Wembley Office) Hirst**
**Research Centre East Lane**
**Wembley Middlesex, HA9 7PP(GB)**

(54) **Display devices.**

(57) A process for manufacturing panels for use in flat panel displays comprises forming a transparent substrate (1), depositing an unpatterned layer (2) of conductive material on the substrate, followed by an unpatterned layer (3) of dielectric material. It is proposed that deposition of the unpatterned layers be carried out by the substrate manufacturer, and that only the patterning of the layers be carried out by the display manufacturer.

FIG 1

This invention relates to display devices and particularly to the manufacture and coating of substrates for flat panel displays.

All of the major types of flat panel displays, namely liquid crystal displays, electroluminescent displays and plasma display panels, are built on glass substrates which are coated with a transparent electrically-conductive layer, normally formed of indium tin oxide (ITO). The ITO layer is generally patterned by a photolithographic process, and it is then often necessary to coat the ITO layer with a layer of silicon dioxide or other dielectric material. In the manufacture of liquid crystal displays the dielectric layer is not essential, but it can improve the yield of the display panels by providing a barrier against short circuits due to microscopic conductive particles which could otherwise damage the panel.

Known processes for depositing the dielectric layer on the glass substrate include vacuum deposition, chemical vapour deposition and the use of a spin-on glass, such as a material designated ZLI 2132 available from E. Merck of Darmstadt, Germany. The first two of these processes provide high-quality films of uniform thickness, but they are expensive and time-consuming. The third process is relatively inexpensive, but provides films of varying thicknesses and of relatively low quality. The variation in thickness, for example from 400-600nm, poses a particular problem in the manufacture of supertwist liquid crystal displays, because the varying thickness causes a variation in the voltage dropped across the dielectric layer in operation of the display. This voltage drop can be a significant proportion of the difference between the voltages applied to pixels which are to be turned on and those which are to be turned off.

The conventional procedure for manufacturing substrates for display panels is for the glass manufacturer to produce large sheets of glass, and to form thereon unpatterned conductive (e.g. ITO) layers. The sheets are then cut into pieces, each of suitable size, e.g. 14 x 14 in.$^2$ for forming display panels. These pieces are then sold to display panel manufacturers, who firstly produce the necessary patterning of the conductive layer, for example by masking and etching, and then deposit the dielectric layer over the conductive layer by one of the processes mentioned above. In view of the cost of depositing the dielectric layer on each individual piece of glass, it is likely that the low-cost, poor quality dielectric layer production technique will in general be used for liquid crystal displays.

It is an object of the present invention to provide a relatively inexpensive process for manufacturing a substrate having an electrically-conductive layer and a high-quality dielectric layer thereon, for use in the construction of one or more flat panel display devices.

According to one aspect of the invention there is provided a process for manufacturing at least one panel to be used in the construction of a flat panel display device, the process comprising forming a transparent substrate, depositing on the substrate an unpatterned layer of electrically-conductive material; and depositing on said unpatterned layer an unpatterned layer of dielectric material.

The substrate may then be cut into pieces suitable for forming panels. It is proposed that the panels should be made up to this stage by the substrate sheet manufacturer.

The conductive layer will be patterned subsequently, during the process of constructing the display device from the panel.

According to another aspect of the invention there is provided a panel to be used in the construction of a flat panel display device, the panel comprising a substrate with an unpatterned layer of electrically-conductive material thereon and an unpatterned layer of dielectric material over the conductive layer.

An embodiment of the invention will now be described, by way of example, with reference to the accompanying drawing, in which

Figure 1 shows a cross-section through a panel for forming a flat panel display device, and

Figure 2 illustrates first stages in the production of a flat panel display device from the panel of Figure 1.

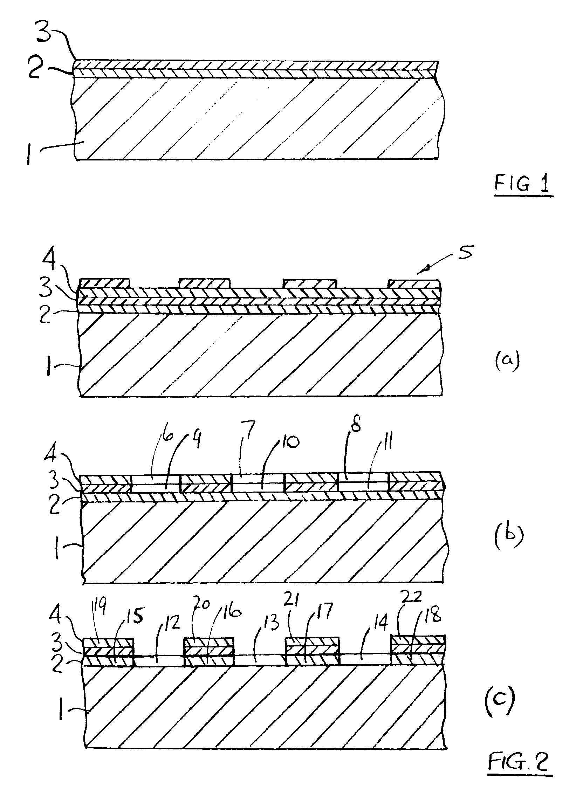

Referring to Figure 1 of the drawing, a substrate 1 of glass or plastics material is produced by the sheet manufacturer, who also deposits thereon a layer 2 of transparent electrically-conductive material, such as indium tin oxide, and a layer 3 of dielectric material, such as silicon dioxide.

The substrate may be very large, i.e. the size of the largest glass or plastics sheet normally manufactured by the sheet manufacturer. It will then be cut into pieces of suitable size, preferably by the sheet manufacturer before delivery to the device manufacturer.

Due to the large sizes which can be dealt with by the sheet manufacturer, the dielectric layer deposition process can be relatively cheap as compared with the cost of the conventional process in which the dielectric layer is deposited on each panel individually by the device manufacturer. That being so, the use of the high-quality chemical vapour deposition or vacuum deposition techniques for depositing the dielectric layer is no longer too expensive, and panels of much better quality can therefore be provided at little or no greater cost than the spin-glass layers conventionally deposited by the device manufacturer.

It is then necessary for the device manufacturer to carry out the patterning of the conductive layer 2, despite the fact that it is covered by the dielectric layer 3. This can be effected as follows, with reference to Figure 2.

The panel is cleaned, and a layer 4 (Figure 2-(a)) of a photoresist material is deposited over the layer 3. A mask 5 carrying suitable patterning for the conductive layer is laid over the layer 4. The photoresist is irradiated through the mask and is then developed in the conventional manner. In the present example a positive photoresist is employed. Clearly the technique could equally well be implemented by use of a negative photoresist.

The areas 6-8 (Figure 2(b)) of the photoresist layer between the required conductor line positions are removed by development of the photoresist, followed by etching of the underlying areas 9-11 of the dielectric layer 3. In the case of a silicon dioxide layer, the etching can be effected by use of a buffered hydrogen fluoride solution.

The panel is then rinsed, and the exposed areas 12-14 (Figure 2(c)) of the conductive layer 2 are etched away leaving the required conductor lines 15-18 beneath the remaining dielectric layer areas. If the conductive layer is ITO, a solution of 50 parts water, 50 parts concentrated hydrochloric acid and 3 parts concentrated nitric acid at around 45°C is a suitable etchant. The remaining areas 19-22 of photoresist are then removed, and the panel is ready for the further stages of display construction.

The dielectric layer forms an excellent resist during the etching of the conductive layer areas 12-14, and thereby greatly reduces the undercutting of the conductor lines which usually occurs during the conventional patterning of the conductive layer in the absence of the dielectric layer. This undercutting presents a particular problem when low-resistivity conductor lines are required. The low resistance is normally achieved by increasing the thickness of the conductive layer, which gives rise to a need for long etching times and hence increased undercutting when the conventional photoresist masking is used.

In the manufacture of some glass substrates, soda-lime glass is used. If such substrates are used untreated for constructing liquid crystal display panels, sodium ions can flow from the glass to the liquid crystal material and adversely affect its characteristics. A blocking layer, such as a layer of silicon dioxide, is therefore used to coat the glass substrate before the conductive layer is deposited. One such blocking material is Permabloc, provided by Pilkington Brothers plc of England. The deposition processes described above can equally well be used over such a blocking layer. Substrates formed of borosilicate glass, such as the material designated 7059 by Corning Incorporated, U.S.A.

are usually provided without such a blocking layer because of their very low sodium content.

The panels described above are especially useful for the construction of liquid crystal displays, such as multiplexed supertwisted liquid crystal displays, but they are clearly also useful in constructing electroluminescent displays and plasma displays.

## Claims

1. A process for manufacturing at least one panel to be used in the construction of a flat panel display device, characterised by forming a transparent substrate (1), depositing on the substrate an unpatterned layer (2) of electrically-conductive material; and depositing on said unpatterned layer an unpatterned layer (3) of dielectric material.

2. A process as claimed in Claim 1, characterised in that the substrate (1) with the conductive layer (2) and the dielectric layer (3) thereon is cut into pieces each suitable for forming one or more display panels.

3. A process as claimed in Claim 1 or Claim 2, characterised in that patterning of the conductive layer (2) is effected by depositing a layer (4) of a photoresist material over the dielectric layer (3); masking, irradiating and developing the photoresist material, thereby exposing areas (9-11) of the dielectric layer; etching away said exposed areas of the dielectric layer thereby exposing areas (12-14) of the conductive layer; and etching away said exposed areas of the conductive layer.

4. A process as claimed in any preceding claim, characterised in that the conductive layer (2) is formed of indium tin oxide.

5. A process as claimed in any preceding claim, characterised in that the dielectric layer (3) is formed of silicon dioxide.

6. A process as claimed in any preceding claim, characterised in that the substrate (1) is formed of glass.

7. A process as claimed in Claim 6, characterised in that the substrate (1) is formed of soda-lime glass; and wherein the glass is coated with a layer of sodium ion blocking material before deposition of the conductive layer (2).

8. A process as claimed in Claim 6, characterised in that the glass is borosilicate glass.

9. A process as claimed in any one of Claims 1-5, characterised in that the substrate (1) is formed of a plastics material.

10. A panel to be used in the construction of a flat panel display device, characterised by a substrate (1) with an unpatterned layer (2) of electrically-conductive material thereon and an unpatterned layer (3) of dielectric material over the conductive layer.

11. A panel as claimed in Claim 10, characterised in that the conductive layer (2) is formed of indium tin oxide.

12. A panel as claimed in Claim 10 or Claim 11, characterised in that the dielectric layer (3) is formed of silicon dioxide.

13. A panel as claimed in any one of Claims 10-12, characterised in that the substrate (1) is formed of glass.

14. A panel as claimed in Claim 13, characterised in that the substrate (1) is formed of soda-lime glass, which is coated with a layer of sodium ion blocking material before deposition of the conductive layer.

15. A panel as claimed in Claim 13, characterised in that the substrate (1) is formed of borosilicate glass.

16. A panel as claimed in any one of Claims 10-12, wherein the substrate (1) is formed of a plastics material.

FIG. 1

FIG. 2